# EUROPEAN PATENT APPLICATION

(11) **EP 4 510 607 A1**
(43) Date of publication of application: **19.02.2025**
(21) Application number: 23869692.6
(22) Date of filing: 01.06.2023
(51) Int. Cl.: H04Q 1/04

(54) **DATA FORWARDING DEVICE, COMPUTING DEVICE, AND CABINET**

(30) Priority: 30.09.2022 CN 202211206927
(71) Applicant: xFusion Digital Technologies Co., Ltd., Zhengzhou, Henan 450000 (CN)
(72) Inventor: XIONG, Xing, Zhengzhou, Henan 450000 (CN); WEI, Dongdong, Zhengzhou, Henan 450000 (CN)
(74) Representative: MERH-IP Matias Erny Reichl Hoffmann Patentanwälte PartG mbB
(86) International application number: PCT/CN2023/097872
(87) International publication number: WO 2024/066439

(57) **Abstract**

A data forwarding device, a computing device, and a cabinet are provided. The data forwarding device includes: an adapter, including a first circuit board, and a plurality of first input interfaces and a plurality of first output interfaces that are connected by using the first circuit board, where the plurality of first output interfaces are classified into N first interface groups, the adapter transmits received signals to the plurality of first output interfaces for output, and N is a positive integer greater than or equal to 2; and at least one network device, where each network device includes a second circuit board, and at least one second input interface and at least one network output interface that are connected by using the second circuit board, the at least one second input interface is plug-connected to one of the first interface groups, so that the network device transmits the received signals to the at least one network output interface for output. The adapter is plug-connected to the network device without cabling. Therefore, signal losses are reduced, space overheads brought by cabling are avoided, and it is conducive to performing maintenance and mounting.

## Description

This application claims priority to Chinese Patent Application No. 202211206927.1, filed with the China National Intellectual Property Administration on September 30, 2022 and entitled "DATA FORWARDING DEVICE, COMPUTING DEVICE, AND CABINET", which is incorporated herein by reference in its entirety.

### TECHNICAL FIELD

This application relates to the field of communication technologies, and in particular, to a data forwarding device, a computing device, and a cabinet.

### BACKGROUND

Popularization of technologies such as cloud computing, big data, and artificial intelligence causes rise of high-density cluster computing. Deployment of a large-scale data center has increasingly high requirements for deployment efficiency and server density. Conventional one-by-one deployment of rack servers cannot meet the requirements. A server and a switch are pre-integrated by using an entire server cabinet, which is deployed in a centralized manner on site for a customer. Therefore, on-site deployment efficiency can be greatly improved and a deployment period is shortened. The pre-integration of the switch and flexible configuration become important specifications of a cabinet server.

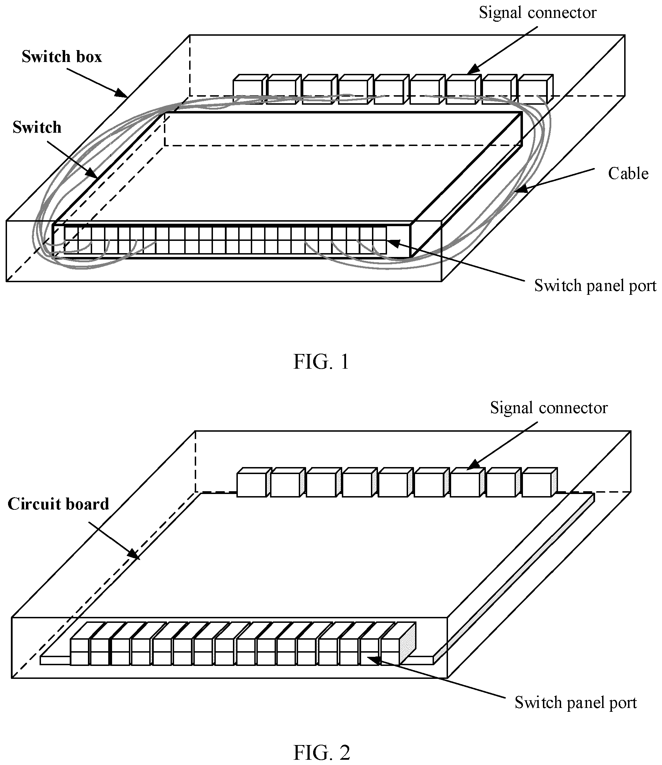

Currently, a switch in a cabinet may be a switch box, and one or more switches are disposed in the switch box. As shown in FIG. 1, a signal connector is disposed in a switch box, a panel interface is disposed on a switch in the switch box, and the signal connector of the switch box is cabled to a panel port of the switch, so that the switch box and the switch are integrated and deployed in a cabinet. In actual applications, the switch is connected to a server in the cabinet by using the signal connector of the switch box as a network interface. For ease of operation and mounting, all panel interfaces of the switch are disposed on a same side, thereby facilitating connection and maintenance.

However, the panel port of the switch in the switch box is connected to the signal connector of the switch box by using a cable, is connected to a signal backplane of the cabinet by using the signal connector, and then is connected to a device (for example, the server). Consequently, overall cabling is long, a high-speed signal has a large loss, and a high-speed network interface cannot be supported.

Information disclosed in the background part is merely intended to enhance the understanding of the general background of this application, and should not be regarded as acknowledging or implying in any form that the information constitutes the conventional technology that is already known to a person skilled in the art.

### SUMMARY

Embodiments of this application provide a data forwarding device, a computing device, and a cabinet. On one hand, an adapter and a network device may be connected in a pluggable manner without cabling. Therefore, signal losses can be reduced, space overheads brought by cabling can be avoided, and it is conducive to performing maintenance and mounting. On the other hand, the network device independently implements a network forwarding function, and a plurality of network devices operate separately, so that normal operation of another network device is not affected when the network device is separately plugged in or plugged out for maintenance.

According to a first aspect, an embodiment of this application provides a data forwarding device, including:
an adapter, including a first circuit board, a plurality of first input interfaces, and a plurality of first output interfaces, where the plurality of first input interfaces are connected to the plurality of first output interfaces by using the first circuit board, the plurality of first input interfaces are connected to a signal backplane, to be connected to a first device by using the signal backplane, the plurality of first output interfaces are classified into N first interface groups, the adapter transmits, to the plurality of first output interfaces for output, signals sent by the first device, and N is a positive integer greater than or equal to 2; and
at least one network device, where each network device includes a second circuit board, at least one second input interface, and at least one network output interface, the at least one second input interface is connected to the plurality of second output interfaces by using the second circuit board, the at least one network output interface is externally connected to at least one second device, and the at least one second input interface is plug-connected to one of the first interface groups, so that the network device transmits, to the at least one network output interface for output, the signals sent by the first device.

In this solution, on one hand, the adapter and the network device may be connected in a pluggable manner without cabling. Therefore, signal losses can be reduced, space overheads brought by cabling can be avoided, and it is conducive to performing maintenance and mounting. On the other hand, the network device independently implements a network forwarding function, and a plurality of network devices operate separately, so that normal operation of another network device is not affected when the network device is separately plugged in or plugged out for maintenance.

In a possible implementation, the first circuit board is a passive circuit board.

In this solution, because the first circuit board is a passive circuit board, and is formed by only circuits, a failure probability is greatly reduced. Therefore, performance of the data forwarding device can be ensured. Subsequently, if the network device fails, the network device may be directly replaced, and the data forwarding device does not need to be directly replaced, so that long-term stability of the data forwarding device is ensured.

In a possible implementation, the network device includes a first component, so as to insert the network device into the data forwarding device and remove the network device from the data forwarding device.

In a possible implementation, the data forwarding device further includes N-1 positioning components, where the network device is disposed between two adjacent positioning components or between the positioning component and a housing of the data forwarding device.

In a possible implementation, the adapter further includes a first power input interface and N first power output interfaces, and the first power input interface is connected to the N first power output interfaces by using the first circuit board; and
the network device further includes a second power input interface and a power module, the second power input interface is connected to the power module by using the second circuit board, the power module is configured to convert power input by the first power input interface into power available for the network device, and the second power input interface is plug-connected to one of the first power output interfaces, so that the first power input interface supplies power to the network device.

In a possible implementation, the at least one second input interface is disposed opposite to the at least one network output interface.

In a possible implementation, the first device is connected to at least one of the N interface groups by using the first circuit board.

According to a second aspect, an embodiment of this application provides a computing device, including a signal backplane, a first device, and the data forwarding device shown in the first aspect, where the first device and the data forwarding device are connected by using the signal backplane.

According to a practicable implementation, the first device is a server. Then, the plurality of first input interfaces of the adapter included in the data forwarding device are connected to the signal backplane, to be connected to the server by using the signal backplane.

In an example, the at least one second device connected to the at least one network output interface includes a server and a switch, so that server expansion can be implemented.

According to a practicable implementation, the network device is a switch.

According to a practicable implementation, the first device is a switch. Then, the plurality of first input interfaces of the adapter included in the data forwarding device are connected to the signal backplane, to be connected to the switch by using the signal backplane.

According to a third aspect, an embodiment of this application provides a cabinet, including the computing device shown in the third aspect. Specifically, the cabinet includes a signal backplane, a first device, and the data forwarding device shown in the first aspect, where the first device and the data forwarding device are connected by using the signal backplane.

According to a practicable implementation, the first device is a server. Then, the plurality of first input interfaces of the adapter included in the data forwarding device are connected to the signal backplane, to be connected to the server by using the signal backplane.

In an example, the at least one second device connected to the at least one network output interface includes a server and a switch, so that server expansion can be implemented.

According to a practicable implementation, the network device is a switch.

According to a practicable implementation, the first device is a switch. Then, the plurality of first input interfaces of the adapter included in the data forwarding device are connected to the signal backplane, to be connected to the switch by using the signal backplane.

### BRIEF DESCRIPTION OF DRAWINGS

FIG. 1 is a schematic diagram of a structure of a customized switch in a conventional technology;
FIG. 2 is a schematic diagram of a structure of a switch housing in a conventional technology;
FIG. 3 is a first schematic diagram of a structure of a data forwarding device according to an embodiment of this application;
FIG. 4a is a first schematic diagram of a connection manner between a first input interface and a first output interface that are provided in FIG. 3;
FIG. 4b is a second schematic diagram of a connection manner between a first input interface and a first output interface that are provided in FIG. 3;
FIG. 5 is a second schematic diagram of a structure of a data forwarding device according to an embodiment of this application;
FIG. 6a is a first schematic diagram of a connection manner between a first input interface and a first output interface that are provided in FIG. 5;
FIG. 6b is a second schematic diagram of a connection manner between a first input interface and a first output interface that are provided in FIG. 5;
FIG. 7a is a first schematic diagram of a structure of three layers of switches according to an embodiment of this application;
FIG. 7b is a second schematic diagram of a structure of three layers of switches according to an embodiment of this application; and
FIG. 8 is a schematic diagram of a structure of a cabinet according to an embodiment of this application.

Reference numerals in the figures are as follows:
100-data forwarding device; 200-first housing; 300-adapter; 310-first circuit board; 320-first input interface; 330-first output interface; 340-first power input interface; 350-first power output interface; 400-network device; 410-second housing; 411-first component; 420-second circuit board; 430-second input interface; 440-network output interface; 450-second power input interface; 460-power module; 470-fan; 480-processing chip; 500-cabinet; 510-signal backplane; and 520-power strip.

### DESCRIPTION OF EMBODIMENTS

To make the objectives, technical solutions, and advantages of the embodiments of this application clearer, the following describes the technical solutions of the embodiments of this application with reference to the accompanying drawings.

In the descriptions of the embodiments of this application, the word such as "exemplary", "for example", or "such as" is used to represent giving an example, an illustration, or a description. Any embodiment or design scheme described as "exemplary", "for example", or "such as" in the embodiments of this application should not be explained as being more preferred or having more advantages than another embodiment or design scheme. Exactly, use of the word "exemplary", "for example", or "such as" is intended to present a relative concept in a specific manner.

In the descriptions of the embodiments of this application, the term "and/or" describes only an association relationship for describing associated objects and represents that three relationships may exist. For example, A and/or B may represent the following three cases: Only A exists, only B exists, and both A and B exist. In addition, unless otherwise specified, the term "a plurality of" means two or more than two. For example, a plurality of systems mean two or more than two systems, and a plurality of terminals mean two or more than two terminals.

In addition, the terms "first" and "second" are merely intended for a purpose of description, and shall not be understood as an indication or implication of relative importance or implicit indication of indicated technical features. Therefore, a feature limited by "first" or "second" may explicitly or implicitly include one or more features. The terms "include", "comprise", "have", and variants thereof all mean "include but are not limited to", unless otherwise specifically emphasized in another manner.

Popularization of technologies such as cloud computing, big data, and artificial intelligence causes rise of high-density cluster computing. Deployment of a large-scale data center has increasingly high requirements for deployment efficiency and server density. Conventional one-by-one deployment of rack servers cannot meet the requirements. A server and a switch are pre-integrated by using an entire server cabinet, which is deployed in a centralized manner on site for a customer. Therefore, on-site deployment efficiency can be greatly improved and a deployment period is shortened. The pre-integration of the switch and flexible configuration become important specifications of a cabinet server.

Currently, there are mainly two types of switches in main cabinets.

Switch A: The switch A is a switch box, and one or more switches are disposed in the switch box.

As shown in FIG. 1, a signal connector is disposed in a switch box, a panel interface is disposed on a switch in the switch box, and the signal connector of the switch box is cabled to a panel port of the switch, so that the switch box and the switch are integrated and deployed in a cabinet. In actual applications, the switch is connected to a server in the cabinet by using the signal connector of the switch box as a network interface. Optionally, a signal backplane is disposed in the cabinet, and a plurality of slots are disposed on the signal backplane. These slots are connected to the server and the switch box, so that the server is connected to the switch box by using the signal backplane. Usually, one or more slots on the signal backplane are configured for one switch box. Optionally, in the cabinet, the server is connected to the signal connector of the switch box by using a cable. It should be noted that, for ease of operation and mounting, all panel interfaces of the switch are disposed on a same side, thereby facilitating connection and maintenance.

Main disadvantages of this solution are as follows:
1. In the switch box, the panel port of the switch is connected to the signal connector by using a cable, and an overall length is long (which usually exceeds 0.5 m). Then the panel port is connected to the signal backplane of the cabinet by using the signal connector, and is connected to a device (for example, the server). Consequently, overall cabling is long, a high-speed signal has a large loss, and a high-speed network interface, for example, a network interface of 25 GE, 50 GE, or 100 GE, cannot be supported.
2. In the switch box, there are many cable connections between the switch and the device in the cabinet, incorrect insertion easily occurs during production and processing, a cabling space is limited, and a height of the switch box needs to be increased. Consequently, a larger space of the cabinet is occupied, resulting in complex cabling and reduced deployment density.
3. If switches in the switch box are stacked and expanded in a longitudinal direction, the height of the switch box is increased, and a larger space of the cabinet is occupied.

Switch B: The switch B is a customized switch. Usually, one slot on a signal backplane is configured for one customized switch.

As shown in FIG. 2, a customized switch includes a circuit board, and a signal connector and a panel interface that are disposed on the circuit board. The panel interface uses a universal network interface (an optical module or an electrical interface), and is connected to another device outside a cabinet, for example, a switch. The signal connector is connected to a server in the cabinet. Optionally, the signal backplane is disposed in the cabinet, and a plurality of slots are disposed on the signal backplane. These slots are connected to the server and the customized switch, so that the server is connected to the customized switch by using the signal backplane. Optionally, in the cabinet, the server is connected to the panel interface of the customized switch by using a cable.

Main disadvantages of this solution are as follows:
1. After the customized switch is connected to the signal backplane in the cabinet, the signal backplane can be fastened to the slot for the switch. In this case, a quantity of switches cannot be expanded in the cabinet, and a plurality of switches cannot be flexibly expanded to adapt to a scenario.
2. Main components of the customized switch are internal. After the main component inside the customized switch is abnormal, the customized switch needs to be removed as a whole for replacement. During replacement, a switching capacity in an entire slot in the cabinet is lost.

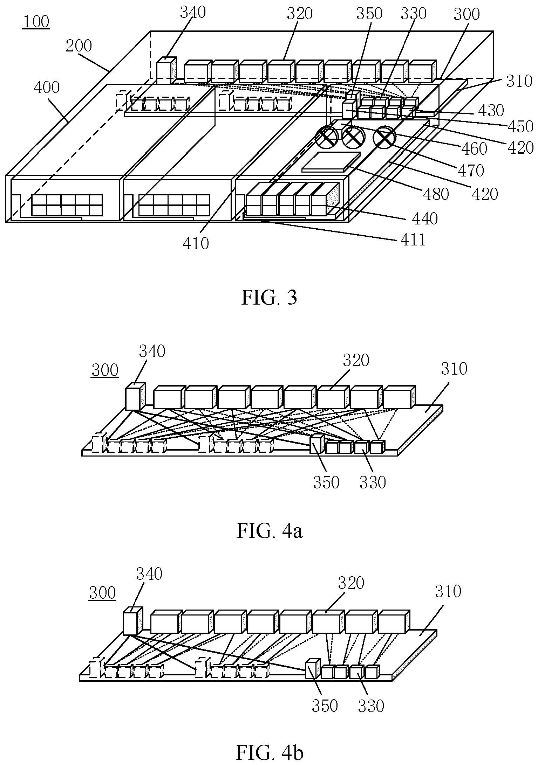

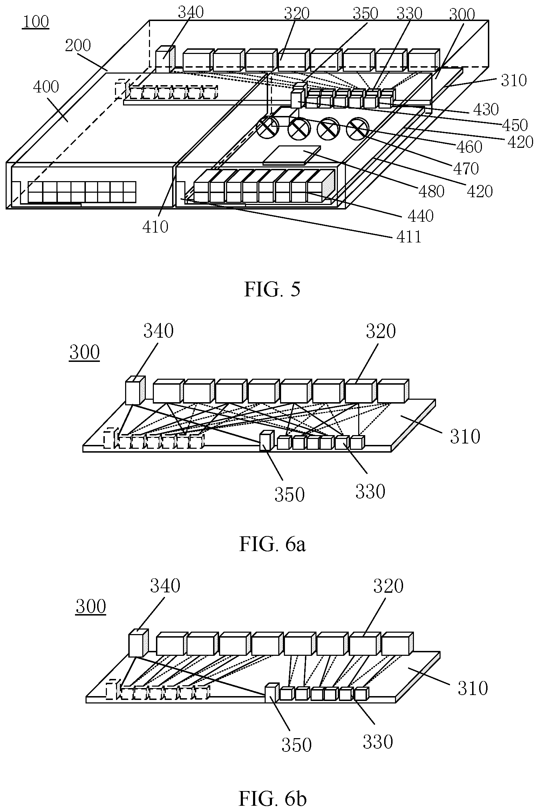

To resolve the foregoing technical problems, as shown in FIG. 3 and FIG. 5, an embodiment of this application provides the following data forwarding device 100.

The data forwarding device 100 includes an adapter 300 and at least one network device 400.

The adapter 300 includes a plurality of first input interfaces 320 and a plurality of first output interfaces 330, where the plurality of input interfaces are externally connected to at least one first device, the plurality of first output interfaces 330 are classified into N first interface groups, the adapter 300 is configured to transmit, to the plurality of first output interfaces 330 for output, signals that are sent by the first device and received by the plurality of first input interfaces 320, and N is a positive integer greater than or equal to 2.

Each network device 400 includes at least one second input interface 430 and at least one network output interface 440. The at least one network output interface is externally connected to at least one second device. The at least one second input interface 430 of the network device 400 is plug-connected to one of the first interface groups of the adapter 300, so that the adapter 300 is electrically connected to the network device 400. In this way, the network device 400 is configured to transmit, to the at least one network output interface 440 for output, the signals that are sent by the first device and received by the at least one second input interface 430. Therefore, a network forwarding function is implemented.

In this solution, on one hand, the adapter 300 and the network device 400 may be connected in a pluggable manner without cabling. Therefore, signal losses can be reduced, space overheads brought by cabling can be avoided, and it is conducive to performing maintenance and mounting. On the other hand, the network device 400 independently implements the network forwarding function, and the network devices 400 independently operate, so that normal operation of another network device 400 is not affected when a network device 400 is separately plugged in or plugged out for maintenance. In addition, the N interface groups are horizontally arranged, a switch is not expanded longitudinally, and an occupied longitudinal space has a height of the network device, so that a space occupied by the data forwarding data can be saved to some extent. Moreover, because the data forwarding device has a limited width, when a plurality of network devices are used, the plurality of network devices are usually small devices. Therefore, the height of the network device can be reduced to some extent, to further save the space occupied by the data forwarding device.

It should be noted that the adapter 300 can access a total of N network devices 400. In actual applications, network devices 400 of a quantity less than N may be flexibly accessed based on an actual requirement.

Herein, a plurality of first input interfaces 320 connected to a same data adapter 300 are classified into one first interface group, and each network device 400 is connected to one first interface group, and is connected in a pluggable manner to the first interface group.

It should be noted that the plurality of first input interfaces 320 are usually connected to a plurality of first devices, and the network output interfaces 440 of each network device 400 may be connected to a plurality of second devices. This embodiment of this application is not intended to limit a quantity of first devices and a quantity of second devices.

It should be noted that a topological connection is used between the plurality of first input interfaces 320 and the N first interface groups, so that the adapter 300 selectively transmits, to the plurality of first output interfaces 330, packets that carry destination addresses and that are sent by the first device and received by the plurality of first input interfaces 320.

It should be noted that the N first interface groups each form a first pattern. The at least one second input interface 430 of each network device 400 forms a second pattern, and the second pattern matches the first pattern to achieve a pluggable connection between the at least one second input interface 430 and the first interface group. The first pattern formed by the first interface group may be understood as a pattern formed by performing orthographic projection on all first output interfaces 330 in the interface group. A total of N first patterns may be formed on the adapter 300. The second pattern formed by the at least one second input interface 430 may be understood as a pattern formed by performing orthographic projection on the at least one second input interface 430. Correspondingly, the second pattern formed by the second input interface 430 of the network device 400 matches several first patterns, so that the network device 400 can be connected in a pluggable manner to a first interface group in which any matched first pattern is located. It should be noted that, when the network device 400 matches a plurality of first patterns, a first interface group for pluggable connection can be flexibly selected. In actual applications, the first patterns formed by the N first interface groups may be the same, may be different, or may be partially the same. This is not specifically limited in this embodiment of this application. Exemplarily, the first patterns formed by the N first interface groups are the same. Correspondingly, the second patterns formed by the second input interfaces 430 on the network device 400 are the same. In this case, the network device 400 may be connected in a pluggable manner to any one of the N first interface groups. It should be noted that the network devices 400 are decoupled from each other. The network device 400 may independently implement an overall packet forwarding function. When the network device 400 is separately plugged in or plugged out for maintenance, normal operation of another network device 400 is not affected.

In actual applications, the quantity N of first interface groups may be flexibly set based on an actual requirement. After the quantity N of first interface groups is determined, a quantity of network devices 400 may be flexibly designed as required. For example, N network devices 400 may be connected. For another example, network devices 400 of a quantity less than N may be connected.

It should be noted that, in actual applications, the signals sent by the first device indicate packets that carry destination addresses. Specifically, a processing chip 480 is disposed in the network device 400. The processing chip 480 is configured to parse the packets that carry destination addresses and that are transmitted by the at least one second input interface 430, determine, based on parsed destination addresses, several network output interfaces 440 for data forwarding, and send the packets that carry destination addresses to the several determined network output interfaces 440 for forwarding. Optionally, a function of the network device 400 may be a function of a switch. Correspondingly, the processing chip 480 may be a switching chip, and the switching chip may perform a simple data forwarding service. That is, the switching chip may directly process data to determine a panel interface for data output. When the service is complex, the processing chip 480 may further include a control chip. In this case, the switching chip needs to process the data by using the control chip, and the control chip may determine the several network output interfaces 440 for packet output, and forward the data through the several determined network output interfaces 440. In addition, the control chip may further configure and manage the switching chip. Optionally, the function of the network device 400 may alternatively be a function of a router, a gateway, or the like. The function of the switch, the router, or the gateway is an existing function. Details are not described.

This embodiment of this application is not intended to limit the quantity of first interface groups. As shown in FIG. 3, N=3. As shown in FIG. 5, N=2.

According to a practicable implementation, the data forwarding device 100 includes a first housing 200, and both the adapter 300 and the network device 400 are disposed in the first housing 200.

Optionally, the first housing 200 is a box body with an opening on one side. On one hand, it is convenient for the network device 400 to be inserted into the box body, to be connected in a pluggable manner to the first interface group of the adapter 300. On the other hand, it is convenient for the network output interface to be externally connected to the second device. Herein, the network output interface 440 is disposed opposite to a second output interface.

Correspondingly, an open slot is disposed on a side opposite to the opening disposed on the first housing 200, and the first input interfaces 320 are disposed at a position of the open slot, so that the first input interfaces 320 are connected to several first devices by using the open slot. In an example, the open slot may include a plurality of through holes, a quantity of through holes matches a quantity of first input interfaces 320, and positions of the through holes match positions of the first input interfaces 320.

According to a practicable implementation, the first input interface 320 may include several signal connecting pieces, one signal connecting cable is configured to connect to one signal, and the several signal connecting pieces form a signal terminal. Herein, the signal connecting pieces may be a pluggable connecting piece, for example, a metal pin, a metal sheet, or a metal pillar.

Exemplarily, the signal connecting pieces in the first input interface 320 are directly connected to the outside. When there are a plurality of cabling connecting cables, the cabling connecting cables may be referred to as a signal array. Correspondingly, a first signal input connector may be a high-precision plug connector, which is usually referred to as a male connector. The high-precision plug connector may be understood as a connector with a small size, and may be connected to the first circuit board 310. It should be noted that a size of the circuit board is small, and correspondingly, the size of the high-precision plug connector is small. For example, the signal connecting piece in the high-precision plug connector may be a PIN pin. Herein, a material of the PIN pin is "tungsten carbide", which is a hard alloy, has high hardness, high strength, good wear resistance, and good corrosion resistance, and is praised as "industrial tooth". The PIN pin is a high-precision product with a tolerance requirement of ±0.001 to ±0.0005.

Exemplarily, if the signal connecting pieces in the first input interface 320 are connected to the outside in a slot manner, the first signal input connector may be a high-precision jack connector, which is usually referred to as a female connector. The high-precision jack connector may be understood as a connector with a small size, and may be connected to the first circuit board 310. It should be noted that the high-precision plug connector or the high-precision jack connector is merely a name given for ease of description and differentiation. In actual applications, another name may alternatively be used. For example, the high-precision jack connector may also be referred to as a high-precision female connector, and the high-precision plug connector may also be referred to as a high-precision male connector.

The first output interface 330 and the second input interface 430 have structures similar to the foregoing structure. Details are not described again.

It should be noted that a quantity of all signal connecting pieces in the first input interface 320 is the same as a quantity of all signal connecting pieces in the first output interface 330. In other words, all the signal connecting pieces in the first input interface 320 are respectively connected to all signal connecting pieces in the second output interface in a one-to-one correspondence. For example, a quantity of all pins in the first input interface 320 is 100, and a quantity of all pins in the first output interface 330 is also 100.

In an example, the first input interface 320 and the second output interface may be integrated and disposed on a same connector.

It should be noted that the first output interface 330 and the second input interface 430 are a high-precision jack connector and a high-precision plug connector, so that a pluggable connection can be implemented. Exemplarily, the first output interface 330 is a high-precision jack connector, and the second input interface 430 is a high-precision plug connector. Exemplarily, the first output interface 330 is a high-precision plug connector, and the second input interface 430 is a high-precision jack connector.

In actual applications, a quantity and positions of first output interfaces 330 correspond to a quantity and positions of second input interfaces 430, so that a pluggable connection can be implemented.

According to a practicable implementation, the plurality of first input interfaces 320 and the plurality of first output interfaces 330 are connected by using the first circuit board 310. Herein, the first circuit board 310 is a PCB (Printed Circuit Board, printed circuit board.

Correspondingly, the first input interfaces 320 and the first output interfaces 330 are disposed on the first circuit board 310. In a specific implementation, the first input interfaces 320 are disposed on a side that is of the first circuit board 310 and that is away from the network device 400, and the first output interfaces 330 are disposed on a side that is of the first circuit board 310 and that is close to the network device 400.

In addition, a plug connector, for example, a pin, is disposed at a position at which the first input interface 320 is in contact with the first circuit board 310, and a through hole that fits with the plug connector of the first input interface 320 is disposed on the first circuit board 310, so that the first input interface 320 can be connected to the first circuit board 310.

Optionally, the first circuit board 310 may be a passive circuit board, and the passive circuit board may be understood as a circuit board on which no active device is disposed. The active device may be understood as an electronic element that requires power to implement a specific function of the electronic element. The first input interface 320 and the first output interface 330 are not active devices. It should be noted that, because the first circuit board 310 is a passive circuit board, the first circuit board 310 is formed by circuits, and a failure probability is greatly reduced. Therefore, performance of the data forwarding device 100 can be ensured. Subsequently, if the network device 400 fails, the network device 400 may be directly replaced, and the data forwarding device 100 does not need to be directly replaced, so that long-term stability of the data forwarding device 100 is ensured.

According to a practicable implementation, the at least one second input interface 430 and the at least one network output interface 440 of the network device 400 are connected by using the second circuit board 420.

Correspondingly, the second input interface 430 and the network output interface 440 are disposed on the second circuit board 420. In a specific implementation, the second input interface 430 is disposed on a side that is of the second circuit board 420 and that is close to the adapter 300, and the network output interface 440 is disposed on a side that is of the second circuit board 420 and that is away from the adapter 300. In addition, a manner of connecting the second input interface 430, the network output interface 440, and the second circuit board 420 is similar to a manner of connecting the first output interface 330 and the first circuit board 310. Details are not described again.

According to a practicable implementation, the network device 400 is provided with a first component 411, and the first component 411 facilitates removal of the network device 400 from the data forwarding device 100. Specifically, the network device 400 has a second housing 410, and the first component 411, for example, a spanner, is disposed on the second housing 410. A user inserts and removes the network device 400 by using the first component 411.

According to a practicable implementation, at least one positioning component (not shown in the figure) is disposed in the first housing 200, and the network device 400 is disposed in an accommodating space formed by two adjacent positioning components, or in an accommodating space formed between the positioning component and the first housing 200, thereby facilitating positioning and mounting of the network device 400.

Specifically, N-1 positioning components are disposed in the housing.

Specifically, the positioning component may be a positioning plate, a positioning block, or the like.

According to a practicable implementation, the adapter 300 further includes a first power input interface 340 and N first power output interfaces 350, where the first power input interface 340 is connected to the N first power output interfaces 350. Optionally, the first power input interface 340 may be connected to the N first power output interfaces 350 by using the first circuit board 310. For a connection between the first power input interface 340 and the first circuit board 310, refer to a connection between the first input interface 320 and the first circuit board 310.

Correspondingly, a second power input interface 450 is further disposed on the network device 400. One of the N first power output interfaces 350 of the N network devices 400 is connected in a pluggable manner to one second power input interface 450, so that the first power input interface 340 supplies power to the network device 400 connected to the first power output interface 350. Optionally, the second power input interface 450 is disposed on the second circuit board 420.

Further, the network device 400 further includes a power module 460, and the power module 460 is configured to convert power transmitted by the second power input interface 450 into power available for the network device 400.

Herein, a plurality of cabling connecting pieces are disposed in the first power input interface 340. For example, the cabling connecting piece may be a pluggable connecting piece, for example, a metal pin, a metal sheet, or a metal pillar. A type of power cable is connected to a cabling connecting piece. There are three types of power cables, which are respectively a live wire, a neutral wire, and a ground wire. A current and a voltage that are provided by the live wire form a loop through the neutral wire, so that the current can pass through. The ground wire enables the current to flow directly into the earth when a short circuit occurs in the circuit, so that safety is ensured and a risk of electric shock is avoided. In actual applications, the plurality of cabling connecting pieces include at least a cabling connecting piece for the live wire and a cabling connecting piece for the neutral wire, and may further include a cabling connecting piece for the ground wire. For example, the first power input interface 340 has only one cabling connecting piece for the live wire, thus implementing single-phase electric power. For example, the first power input interface 340 may have three cabling connecting pieces for the live wires, thus implementing three-phase electric power.

If the first power input interface 340 is directly connected to the outside by using the cabling connecting piece, the first power input connection is a plug connector. Herein, the plug connector may be understood as a connector with a large size. For example, the plug connector may be a connector C20 or C14 of an IEC 60320 power cable.

If the cabling connecting piece of the first power input interface 340 is connected to the outside in a jack manner, correspondingly, the first power input interface 340 is a jack connector. Herein, the jack connector may be understood as a connector with a large size. For example, the jack connector may be a connector C10 or C13 of an IEC 60320 power cable.

It should be noted that, in actual applications, the first power input interface 340 usually needs to be connected to a power strip 520, and a plurality of jacks are disposed on the power strip 520. Therefore, the first power input interface 340 is usually a plug connector, so that a first power connector is inserted into the jacks to implement connection.

The first power output interface 350 and the second power input interface 450 have structures similar to the foregoing structure. Details are not described again.

Optionally, an interface group and a first power input interface 340 of the adapter 300 are connected in a pluggable manner to a second power input interface 450 and second input interfaces 430 of one network device 400. Specifically, the first power output interface 350 and the second power input interface 450 are a jack connector and a plug connector, so that a pluggable connection can be implemented. Exemplarily, the first power output interface 350 is a jack connector, and the second power input interface 450 is a plug connector. Exemplarily, the first power output interface 350 is a plug connector, and the second power input interface 450 is a jack connector.

It should be noted that the first power output interface 350 matches the second power input interface 450 in a quantity of cabling cabling connecting pieces and a type of a connected cable. For example, the first power output interface 350 includes three cabling connecting pieces, which are respectively connected to a live wire, a neutral wire, and a ground wire. In this case, the second power input interface 450 has three cabling connecting pieces, which are respectively connected to the live wire, the neutral wire, and the ground wire. The cabling connecting pieces for the live wire are connected by using the live wire, the cabling connecting pieces for the neutral wire are connected by using the neutral wire, and the cabling connecting pieces for the ground wire are connected by using the ground wire.

According to a practicable implementation, the network device 400 further includes a fan 470, and the fan 470 is configured to dissipate heat from the network device 400.

The following describes the first device and the second device with reference to application scenarios of the embodiments of this application.

In actual applications, interaction between a plurality of servers is implemented by using a communication network system. The communication network system may be established by using switches with a tree topology, and usually includes an access layer, a convergence layer, and a core layer.

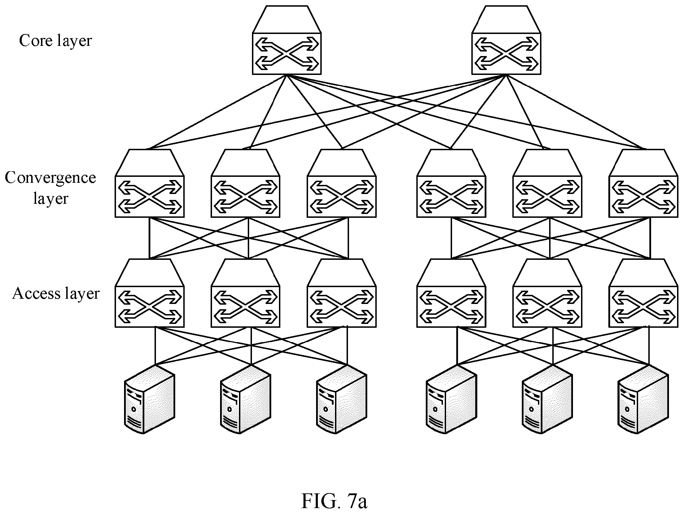

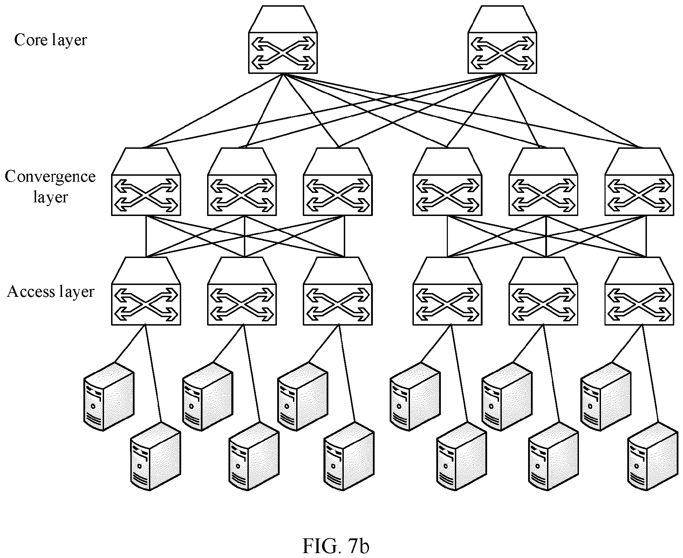

The access layer allows devices to be connected to a network. Therefore, the devices connected to switches at the access layer may be electronic devices that have data processing and network communication capabilities, for example, a server and a switch. As shown in FIG. 7a, the switches at the access layer and the servers are fully connected. As shown in FIG. 7b, one server is connected to one switch at the access layer, and one switch may be connected to a plurality of servers.

The convergence layer is a convergence point for the switches at the access layer. The convergence layer needs to be able to process all communication traffic from the switches at the access layer and provide the communication traffic to an uplink of the core layer. Therefore, compared with the switches at the access layer, switches at the convergence layer require better performance, fewer interfaces, and higher switching rates. As shown in FIG. 7a and FIG. 7b, the switches at the access layer and the switches at the convergence layer are fully connected.

A main objective of the core layer is to provide a reliable backbone transmission structure through high-speed forwarding communication. Therefore, switches at the core layer need to have higher reliability, better performance, and higher throughput. As shown in FIG. 7a and FIG. 7b, the switches at the core layer and the switches at the convergence layer are fully connected.

Correspondingly, the network device 400 in the data forwarding device 100 may be a switch. The network device 400 provided in this embodiment of this application may be a switch at the access layer or a switch at the convergence layer.

According to a practicable implementation, the first device connected to the first input interface 320 may be a server, and the second device connected to a part of the network output interfaces 440 may be a server, so that a quantity of servers connected to the network device 400 is expanded. It should be noted that the network device 400 may be a switch at the access layer, and the second device connected to another part of the network output interfaces 440 may be a switch at the convergence layer.

According to a practicable implementation, the first device connected to the first input interface 320 may be a server, the network device 400 is a switch at the access layer, and the second device connected to the network output interfaces 440 may be a switch at the convergence layer, so that a communication network is established.

According to a practicable implementation, the first device connected to the first input interface 320 may be a switch at the access layer, the network device 400 is a switch at the convergence layer, and the second device connected to the network output interfaces 440 may be a switch at the core layer, so that a communication network is established.

According to a practicable implementation, the first device is connected to at least one of the N interface groups of the adapter 300.

In an example, the first device is connected to each of the N interface groups of the adapter 300. In other words, the topological connection used between the plurality of first input interfaces 320 and the N first interface groups is a first connection, and the first connection indicates the connection between the first device and each of the N interface groups of the adapter 300.

In a specific implementation, the first device is connected to the N interface groups of the adapter 300 by using the first circuit board 310.

For example, it is assumed that a network interface of one first device is connected to one of the first input interfaces 320, and the first input interface 320 is connected to network interfaces of one or more devices. Each first input interface 320 is connected to the N first interface groups, achieving a full connection between the first device and the N interface groups.

As shown in FIG. 4a, each first output interface 330 is connected to three first interface groups, so that each first interface group obtains backplane signals of a same quantity.

As shown in FIG. 6a, each first output interface 330 is connected to two first interface groups, so that each first interface group obtains signals of a same quantity.

For example, when there are 36 first devices, each first interface group is interconnected to the 36 first devices, to implement a switching function among the 36 first devices.

In an example, the first device is connected to some of the N interface groups of the adapter 300. In other words, the topological connection used between the plurality of first input interfaces 320 and the N first interface groups is a second connection, and the second connection indicates connections between the first device and some of the N interface groups of the adapter 300.

In a specific implementation, the first device is connected to some of the N interface groups of the adapter 300 by using the first circuit board 310.

For example, it is assumed that a network interface of one first device is connected to one of the first input interfaces 320, and the first input interface 320 is connected to network interfaces of one or more devices. Some of the first input interfaces 320 are connected to one interface group.

As shown in FIG. 4b, the first output interfaces 330 are evenly classified into three parts of signals, and each part of signals are connected to one first interface group, so that each first interface group obtains a part of signals. For example, when there are 36 first devices, each first interface group is interconnected to 12 first devices, and a tripled bandwidth is implemented between each network device 400 and the first device relative to a topology 1, so that three network devices 400 jointly implement a switching function among the 36 first devices.

As shown in FIG. 6b, the first output interfaces 330 are evenly classified into two parts of signals, and each part of signals are connected to one first interface group, so that each first interface group obtains a part of signals. For example, when there are 36 first devices, each first interface group is interconnected to 18 first devices, and a doubled bandwidth is implemented between each network device 400 and the first device relative to a topology 1, so that two network devices 400 jointly implement a switching function among the 36 first devices.

According to a practicable implementation, the first input interface 320 may be cabled to the first device.

According to a practicable implementation, the first input interface 320 may be connected to the first device by using the signal backplane 510 in the cabinet 500.

Referring to FIG. 3, the following provides a specific embodiment of the data forwarding device 100. It should be understood that the data forwarding device 100 may alternatively be in another form, and is not limited to the following embodiment.

A data forwarding device 100 includes a first housing 200, and an adapter 300 and three network devices 400 that are disposed in the first housing 200.

The first housing 200 has an opening on one side, and an open slot is disposed on a side opposite to the opening. Two baffles are disposed in the first housing 200 to form three accommodating spaces.

The adapter 300 includes a first circuit board 310, where the first circuit board 310 does not include an active device, and a plurality of first input interfaces 320, a plurality of first output interfaces 330, a first power input interface 340, and N second power output interfaces are disposed on the first circuit board 310. The first input interfaces 320 and the first power input interface 340 are disposed on a side that is of the first circuit board 310 and that is away from the network devices 400, the first output interfaces 330 and the first power output interfaces 350 are disposed on a side that is of the first circuit board 310 and that is close to the network devices 400, and the plurality of first input interfaces 320 are classified into three first interface groups. Each of the three first interface groups faces one accommodating space, and different interface groups face different accommodating spaces.

The network device 400 includes a second housing 410, where a second circuit board 420 is disposed in the second housing 410, and several second input interfaces 430, several network output interfaces 440, one second power input interface 450, a processing chip 480, a power module 460, and a fan 470 are disposed on the second circuit board 420. A first component 411 is disposed on a surface that is of the second housing 410 and that is away from the first circuit board 310, so that the insertion of the network device 400 into the accommodating space in the data forwarding device 100 is facilitated; an open slot is disposed on a surface that is of the second housing 410 and that is close to the adapter 300, for plug-connection with the first input interfaces 320 in the first interface group of the adapter 300 by using the open slot; and the power module 460 is connected to the second power input interface 450, so that power input by the second power input interface 450 can be converted into power available for the processing chip 480, for example, power of 220 V is converted into power of 5 V or 12 V. The second input interfaces 430 and the second power input interface 450 are disposed on a side that is of the second circuit board 420 and that is close to the adapter 300, and the network output interfaces 440 are disposed at an opening of the first housing 200, to be connected to the outside.

The second input interfaces 430 of the three network devices 400 are connected in a pluggable manner to the three first interface groups.

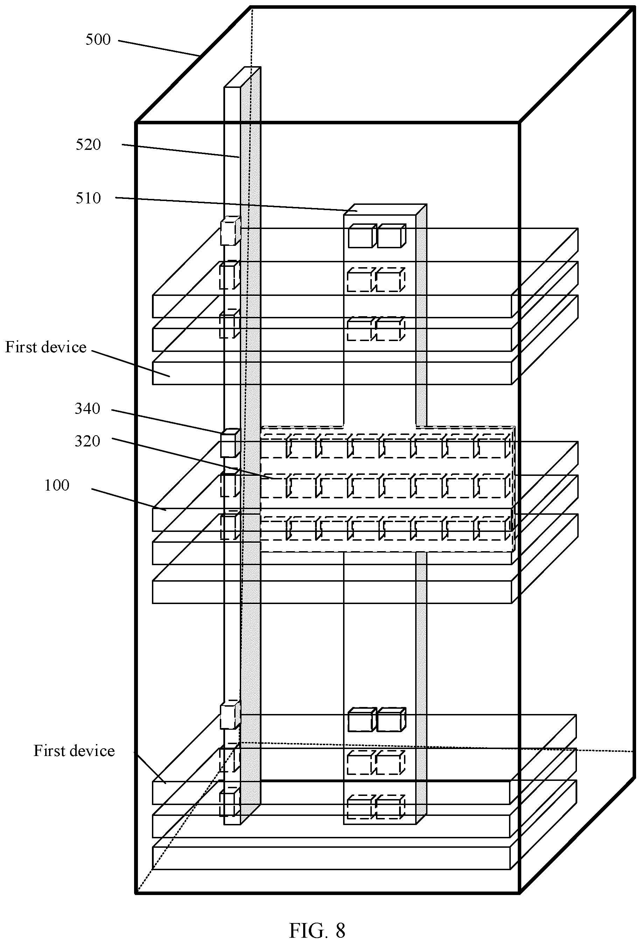

In actual applications, the data forwarding device 100 may be disposed in a cabinet 500. Based on this, as shown in FIG. 8, an embodiment of this application provides the following cabinet 500.

The cabinet 500 includes a signal backplane 510, several first devices, and several data forwarding devices 100. The several first devices and the several data forwarding devices 100 are connected by using the signal backplane 510. Specifically, the first devices and the data forwarding devices 100 are connected to the signal backplane 510.

In a specific implementation, the signal backplane 510 includes n first slots (not shown in the figure) and m second slots (not shown in the figure). Herein, each of the m second slots may be connected in a pluggable manner to the first input interfaces 320 of one data forwarding device 100, and a total of m data forwarding devices 100 may be connected to the m second slots. Herein, the first slot is connected to the first device, so that the first device is connected to the data forwarding device 100 by using the signal backplane 510.

In actual applications, the data forwarding devices 100 may be flexibly accessed based on an actual requirement, for example, less than or equal to m, so that the quantity of data forwarding devices 100 is flexibly expanded.

In this solution, each second slot in the entire cabinet 500 is connected in a pluggable manner to the first input interfaces 320 of the data forwarding device 100, so that the second slot of the cabinet 500 is decoupled from a network device 400. The cabinet 500 may be flexibly configured as required, so that a plurality of network devices 400 can be expanded, and density and flexible configuration of the network devices 400 in the cabinet 500 can be improved.

It should be noted that the m data forwarding devices 100 respectively connected to the m second slots may have a same quantity or different quantities of network devices 400. In actual applications, considering aesthetics and maximum space utilization, the m data forwarding devices 100 usually have a same quantity of network devices 400, so that maximum utilization of a horizontal space in the cabinet 500 is achieved. In addition, the data forwarding device 100 is connected in a pluggable manner to the second slot. In actual applications, the first input interfaces 320 of the data forwarding device 100 may be a high-precision plug connector, and may be connected in a pluggable manner to the second slot. The first device is also connected in a pluggable manner to the first slot.

In actual applications, several signal connecting pieces may be disposed in the first slot, and several signal connecting pieces may also be disposed in the second slot. Cabling is performed on the signal backplane 510, so that the signal connecting pieces in the first slot are connected to the signal connecting pieces in the second slot, and the first device is connected to a forwarding module by using the first slot and the second slot. Therefore, the quantity of network devices 400 can be flexibly expanded. Specifically, one signal connecting piece in the first slot is connected to one signal connecting piece in the second slot.

According to a practicable implementation, the first device is connected to each of the N interface groups of the adapter 300. That is, in a scenario of the connection manner between the first input interfaces 320 and the first output interfaces 330 shown in FIG. 4a and FIG. 6a, all the signal connecting pieces in each first slot are connected to the m second slots. In other words, all signals of the first slot flow to the m second slots. For any second slot, all the signal connecting pieces in the second slot are classified into n signal connecting piece groups. Different signal connecting pieces in each signal connecting piece group are connected to different network devices 400. Then, a signal connecting piece group is connected to a same first slot, and the n signal connecting piece groups are respectively connected to different first slots. When the n first slots are connected to n first devices, and the m second slots are connected to the m data forwarding devices 100, each first device is connected to each first interface group of the m data forwarding devices 100. Subsequently, the quantity of network devices 400 can be flexibly set, so that some and all first interface groups are connected in a pluggable manner to the network device 400.

In an example, the first slot is connected to a server, and the second slot is connected to a switch (the network device 400) at an access layer. In actual applications, a second device connected to the switch (the network device 400) that is connected to the second slot and that is at the access layer is a switch at a convergence layer.

Exemplarily, it is assumed that the quantity n of first slots is 36, and a total of 36 servers may be connected to the cabinet 500. A quantity of second slots may not be limited, and may be flexibly designed based on an actual requirement. It is assumed that three switches and one adapter 300 are disposed in one quantity forwarding device, 36 network output interfaces 440 are disposed on each switch, one network output interface 440 may be connected to one server, and a total of 36 servers may be connected to each switch. In addition, the 36 servers may be connected to the m data forwarding devices 100 by using the signal backplane 510, to implement a packet forwarding function among the 36 servers.

In an example, the first slot is connected to a switch at the access layer, and the second slot is connected to a switch (the network device 400) at the convergence layer. In actual applications, the second device connected to the switch (the network device 400) that is connected to the second slot and that is at the convergence layer is a switch at a core layer. A structure of the switch at the access layer is the same as that of the switch at the convergence layer. For example, one adapter 300 and three switches are disposed in one data forwarding device 100, eight network output interfaces 440 are disposed on each switch, one network output interface 440 may be connected to one switch, each switch may be connected to a total of eight switches, and each data forwarding device 100 may be connected to a total of 24 switches. Then, both the quantity n of first slots and the quantity m of second slots are 8. Therefore, the 24 switches (the first devices) that are at the access layer and that are connected to the first slots and the 24 switches (the network devices 400) that are at the convergence layer and that are connected to the second slots are fully connected.

According to a practicable implementation, the first device is connected to one of the N interface groups of the adapter 300. That is, in a scenario of the connection manner between the first input interfaces 320 and the first output interfaces 330 shown in FIG. 4b and FIG. 6b, one first slot is connected to one second slot. Specifically, one first device is connected to one network device 400, and one network device 400 may be connected to one or more first devices. Specifically, all the signal connecting pieces in each first slot are connected to one second slot. In other words, all the signals in the first slot flow to one second slot. For different signal connecting pieces that are in the second slot and that are connected to a same network device 400, the different signal connecting pieces are connected to different first slots, and signal connecting pieces in different second slots are connected to different first slots. When the n first slots are connected to the n first devices, and the m second slots are connected to the m data forwarding devices 100, the n first devices are connected to any first interface group of the m data forwarding devices 100. Subsequently, the quantity of network devices 400 can be flexibly set, so that some and all first interface groups are connected in a pluggable manner to the network device 400.

In an example, one server is connected to one switch at the access layer, and one switch at the access layer may be connected to one or more servers. Correspondingly, the first slot is connected to a server, and the second slot is connected to a switch (the network device 400) at the access layer. In actual applications, the second device connected to the switch (the network device 400) that is connected to the second slot and that is at the access layer is a switch at the convergence layer.

Exemplarily, it is assumed that the quantity m of second slots is 2. Three switches and one adapter 300 are disposed in one data forwarding device 100, and the three switches are respectively connected to three first interface groups of the adapter 300 in a one-to-one correspondence. A total of eight signal connecting pieces are disposed in the second input interface 430 disposed on each switch, one signal connecting piece may be connected to one server, and each switch may be connected to a total of eight servers. Then, each data forwarding device 100 may be connected to 24 servers, and two data forwarding devices 100 connected to the two second slots may be connected to a total of 48 servers. The quantity n of first slots is 48.

For example, when the quantity n of first slots in the cabinet 500 is 36, each first slot is connected to one server, and the 36 first slots are connected to a total of 36 servers, each switch in the data forwarding device 100 is interconnected to 12 servers, and a tripled bandwidth is implemented between each switch and the server relative to a topology 1, so that three switches jointly implement a switching function among the 36 servers.

For example, when the quantity n of first slots in the cabinet 500 is 36, each first slot is connected to one server, and the 36 first slots are connected to a total of 36 servers, each switch in the data forwarding device 100 is interconnected to 18 servers, and a doubled bandwidth is implemented between each switching plug-in card and the server relative to a topology 1, so that two switching plug-in cards jointly implement a switching function among the 36 servers.

Further, the cabinet 500 further includes a power strip 520, where a plurality of socket holes are disposed on the power strip 520, and a quantity of the plurality of socket holes is at least greater than m. Correspondingly, the first power input interface 340 disposed in the forwarding module in the data forwarding device 100 is a plug connector, which may be inserted into the socket holes. For example, the power strip 520 may be a copper busbar, or may be a PDU (Power Distribution Unit, power distribution unit).

In the foregoing embodiments, descriptions of the embodiments have respective focuses. For a part that is not described or recorded in detail in an embodiment, refer to related descriptions in another embodiment.

The foregoing describes the basic principles of the embodiments of this application with reference to specific embodiments. However, it should be noted that advantages, effects, and the like mentioned in the embodiments of this application are merely examples but not limitations, and these advantages, effects, and the like cannot be considered as being necessary for the embodiments of the present disclosure. In addition, the foregoing disclosed specific details are merely intended to serve as examples and to facilitate understanding, instead of limitations. The present disclosure is not limited to be implemented by using the foregoing specific details.

It should also be noted that in the devices and modules of the present disclosure, components may be decomposed and/or recombined. The decomposition and/or recombination shall be considered as equivalent solutions of the present disclosure.

The foregoing descriptions are already given for the objectives of illustration and description. Further, the descriptions are not intended to limit the embodiments of the present disclosure to be in the forms disclosed herein. Although a plurality of example aspects and embodiments are already discussed above, a person skilled in the art will recognize some variations, modifications, changes, additions, and subcombinations thereof.

It may be understood that various numeric numbers in the embodiments of this application are merely descriptions for convenient differentiation, and are not used to limit the scope of the embodiments of this application.

## Claims

1. A data forwarding device, comprising:
an adapter, comprising a first circuit board, a plurality of first input interfaces, and a plurality of first output interfaces, wherein the plurality of first input interfaces are connected to the plurality of first output interfaces by using the first circuit board, the plurality of first input interfaces are externally connected to at least one first device, the plurality of first output interfaces are classified into N first interface groups, the adapter transmits, to the plurality of first output interfaces for output, signals sent by the first device, and N is a positive integer greater than or equal to 2; and
at least one network device, wherein each network device comprises a second circuit board, at least one second input interface, and at least one network output interface, the at least one second input interface is connected to the plurality of second output interfaces by using the second circuit board, the at least one network output interface is configured to connect to at least one second device, and the at least one second input interface is plug-connected to one of the first interface groups, so that the network device transmits, to the at least one network output interface for output, the signals sent by the first device.

2. The data forwarding device according to claim 1, wherein the first circuit board is a passive circuit board.

3. The data forwarding device according to claim 1, wherein the network device comprises a first component, so as to insert the network device into the data forwarding device and remove the network device from the data forwarding device.

4. The data forwarding device according to claim 1, further comprising N-1 positioning components, wherein the network device is disposed between two adjacent positioning components or between the positioning component and a housing of the data forwarding device.

5. The data forwarding device according to claim 1, wherein the adapter further comprises a first power input interface and N first power output interfaces, and the first power input interface is connected to the N first power output interfaces by using the first circuit board; and
the network device further comprises a second power input interface and a power module, the second power input interface is connected to the power module by using the second circuit board, the power module is configured to convert power input by the first power input interface into power available for the network device, and the second power input interface is plug-connected to one of the first power output interfaces, so that the first power input interface supplies power to the network device.

6. The data forwarding device according to claim 1, wherein the at least one second input interface is opposite to the at least one network output interface.

7. The data forwarding device according to claim 1, wherein the first device is connected to at least one of the N interface groups by using the first circuit board.

8. A computing device, comprising a signal backplane, a server, and a data forwarding device, wherein the server is connected to the signal backplane, and the data forwarding device comprises:
an adapter, comprising a first circuit board, a plurality of first input interfaces, and a plurality of first output interfaces, wherein the plurality of first input interfaces are connected to the plurality of first output interfaces by using the first circuit board, the plurality of first input interfaces are connected to the signal backplane, to be connected to the server by using the signal backplane, the plurality of first output interfaces are classified into N first interface groups, the adapter transmits, to the plurality of first output interfaces for output, signals sent by the server, and N is a positive integer greater than or equal to 2; and
at least one network device, wherein each network device comprises a second circuit board, at least one second input interface, and at least one network output interface, the at least one second input interface is connected to the plurality of second output interfaces by using the second circuit board, the at least one network output interface is externally connected to at least one second device, and the at least one second input interface is plug-connected to one of the first interface groups, so that the network device transmits, to the at least one network output interface for output, the signals sent by the server.

9. The computing device according to claim 8, wherein the network device is a switch.

10. A cabinet, comprising:
a signal backplane, a first device, and a data forwarding device, wherein the first device is connected to the signal backplane, and the data forwarding device comprises:
an adapter, comprising a first circuit board, a plurality of first input interfaces, and a plurality of first output interfaces, wherein the plurality of first input interfaces are connected to the plurality of first output interfaces by using the first circuit board, the plurality of first input interfaces are connected to the signal backplane, to be connected to the first device by using the signal backplane, the plurality of first output interfaces are classified into N first interface groups, the adapter transmits, to the plurality of first output interfaces for output, signals sent by the first device, and N is a positive integer greater than or equal to 2; and
at least one network device, wherein each network device comprises a second circuit board, at least one second input interface, and at least one network output interface, the at least one second input interface is connected to the plurality of second output interfaces by using the second circuit board, the at least one network output interface is externally connected to at least one second device, and the at least one second input interface is plug-connected to one of the first interface groups, so that the network device transmits, to the at least one network output interface for output, the signals sent by the first device.
